# EUROPÄISCHE PATENTSCHRIFT

(11) **EP 1 865 565 B1**
(45) Veröffentlichungstag und Bekanntmachung des Hinweises auf die Patenterteilung: **05.08.2009**
(21) Anmeldenummer: 07106691.4
(22) Anmeldetag: 23.04.2007
(51) Int. Cl.: H01L 41/083, H01L 41/04

(54) **System zum Betreiben eines piezoelektrischen Elements**
System for operating a piezo-electric element
Système d'exploitation d'un élément piézo-électrique

(30) Priorität: 08.06.2006 DE 102006026642
(43) Veröffentlichungstag der Anmeldung: 12.12.2007
(73) Patentinhaber: ROBERT BOSCH GMBH, 70442 Stuttgart (DE)
(72) Erfinder: Hedenetz, Andreas, 73770 Denkendorf (DE); Boecking, Friedrich, 70499 Stuttgart (DE); Schenk, Robert, 71665 Vaihingen/Enz (DE); Ziegler, Marcus, 36088 Hünfeld (DE)

(56) Entgegenhaltungen:
- EP-A- 1 429 445
- EP-A- 1 555 699
- DE-A1- 10 306 296
- DE-A1- 19 653 555
- DE-C1- 19 615 694

## Beschreibung

### Stand der Technik

### Beschreibung

Die Erfindung betrifft ein System zum Betreiben eines piezoelektrischen Elements, wobei das System ein Element und eine Steuereinheit zum Ansteuern des Elements aufweist. Üblicherweise ist die Steuereinheit zum Ansteuern des piezoelektrischen Elements in einem Steuergerät angeordnet. Diese Steuergeräte haben eine Vielzahl von Eingängen und Ausgängen. Beim Betrieb dieser Steuergeräte entsteht - unter anderem aufgrund der stetig steigenden Integrationsdichte von elektronischen Bauelementen bei gleichzeitig sinkenden Geräteabmessungen - eine erhebliche Verlustwärme, die zu hohen Temperaturbelastungen des Steuergeräts führt. Dadurch leiden Lebensdauer und Zuverlässigkeit der Steuergeräte.

Darüber hinaus nutzen viele aus dem Stand der Technik bekannte Steuergeräte bereits heute eine maximal mögliche unter anderem aufgrund der Gehäuseform begrenzte Anzahl von Kontaktierungselementen, zum Beispiel zum Anschluss von Stellgliedern, Sensorelementen oder dergleichen und weisen dementsprechend eine geringe Erweiterbarkeit auf.

Demgemäss ist es Aufgabe der vorliegenden Erfindung, ein System zum Betreiben eines piezoelektrischen Elements bereitzustellen, das die oben genannten Nachteile vermeidet oder zumindest deutlich reduziert.

Aus der DE 196 53 555 A1 ist bereits ein piezoelektrischer Aktor bekannt, der beispielsweise zum Ansteuern eines Servoventils eines Einspritzventils oder unmittelbar zum Betätigen einer Ventilnadel in einem Einspritzventil dient. Der piezoelektrische Aktor weist eine Vielzahl von piezoelektrischen Elementen auf, die teilweise von Haltemitteln umgeben sind, um ein seitliches Knicken der piezoelektrischen Elemente zu verhindern. Diese Gesamtanordnung ist wiederum von einem Federelement umgeben. Auf diese Weise ist der piezoelektrische Aktor in gewünschter Weise vorgespannt. Der piezoelektrische Aktor weist zudem eine Kopfplatte auf, die die piezoelektrischen Elemente stirnseitig deckelt. In der Kopfplatte sind Steuermittel vorgesehen, die über Steuerleitungen direkt mit den piezoelektrischen Elementen verbunden sind.

### Offenbarung der Erfindung

Diese Aufgabe wird gemäß Anspruch 1 der Erfindung bei einem System zum Betreiben eines piezoelektrischen Elements, wobei das System ein Element und eine Steuereinheit zum Ansteuern des Elements aufweist, wobei das Element einen Stapel aus mehreren piezoelektrischen Keramikschichten umfasst, wobei zwischen den Keramikschichten jeweils eine Elektrodenschicht vorgesehen ist, und wobei die Steuereinheit mindestens ein Substrat umfasst, dadurch gelöst, dass das oder die Substrate der Steuereinheit zwischen mehreren keramischen Schichten des piezoelektrischen Elements angeordnet sind.

### Vorteile der Erfindung

Durch die erfindungsgemäße Anordnung der Steuereinheit in dem piezoelektrischen Element können verschiedene Funktionalitäten aus dem übergeordneten Steuergerät herausgenommen und zu dem piezoelektrischen Element verlagert werden. Dadurch wird naturgemäß das übergeordnete Steuergerät entlastet.

Besonders geeignet zur Auslagerung vom Steuergerät in eine Steuereinheit ist beispielsweise eine Auswerteelektronik eines als Sensor eingesetzten piezoelektrischen Elements oder eine Leistungsendstufe zur Ansteuerung eines als Aktor eingesetzten piezoelektrischen Elements. Wenn die Leistungsendstufen aus dem Steuergerät herausgenommen und direkt im piezoelektrischen Aktor angeordnet werden, wird die thermische Belastung der im übergeordneten Steuergerät verbliebenen elektrischen Bauteile und Schaltkreise stark reduziert, was deren Zuverlässigkeit und Lebensdauer erhöht.

Des Weiteren wird durch die Auslagerung von Funktionen, die unmittelbar mit dem piezoelektrischen Aktor zu tun haben, naturgemäß auch der im Steuergerät vorhandene verfügbare Bauraum vergrößert und die Zahl der verfügbaren Kontaktierungselemente nimmt zu. Dadurch können die Steuergeräte besser erweitert werden.

Schließlich ist ein weiterer sehr wesentlicher Vorteil darin zu sehen, dass sowohl piezoelektrische Elemente als auch die Substrate von elektronischen Schaltungen, wie sie jede Steuereinheit aufweist, unter ähnlichen äußeren Bedingungen (Reinraumbedingungen) und mit teilweise gleichen oder ähnlichen Technologien hergestellt werden. Dadurch ist es möglich, die Herstellung sowohl der piezoelektrischen Elemente als auch der zugehörigen Steuereinheit an einem Ort zusammenzuführen, wobei am Ende des Fertigungsprozesses das fertige piezoelektrische Element mit der zugehörigen Steuereinheit steht. Dadurch lassen sich erhebliche Synergie- und Kosteneinsparpotenziale realisieren.

Wie bereits angedeutet, kann das erfindungsgemäße piezoelektrische Element sowohl als piezoelektrischer Aktor als auch als piezoelektrischer Sensor ausgebildet sein. Es ist selbstverständlich auch möglich, dass ein und dasselbe piezoelektrische Element zeitweise als piezoelektrischer Aktor und zeitweise als piezoelektrischer Sensor genutzt wird.

Es hat sich als besonders vorteilhaft erwiesen, wenn die Steuereinheit eine Leistungsendstufe umfasst und wenn die Leistungsendstufe auf einem ersten Teilsubstrat der Steuereinheit angeordnet ist. Selbstverständlich ist es auch möglich, dass alle Funktionalitäten der Steuereinheit auf einem Substrat zusammengefasst sind.

Eine weitere vorteilhafte Ausgestaltung der Erfindung sieht vor, dass die Steuereinheit eine integrierte Schaltung für die Auswertung eines oder mehrerer Sensoren, insbesondere piezoelektrischer Sensoren aufweist. Besonders bevorzugt ist dabei, wenn diese integrierte Schaltung für die Auswertung des oder der Sensoren auf einem zweiten Teilsubstrat angeordnet ist.

Falls erforderlich, kann zwischen den keramischen Schichten des piezoelektrischen Elements und dem Substrat oder den Substraten der Steuereinheit eine oder bei Bedarf mehrere Zwischenschichten angeordnet werden. Diese Zwischenschichten können beispielsweise zur besseren Verbindung von Steuereinheit und piezoelektrischem Element erforderlich sein.

Es hat sich weiter als vorteilhaft erwiesen, wenn die Steuereinheit vorzugsweise eine als anwendungsspezifische integrierte Schaltung (ASIC) oder als Mikrocontroller ausgebildete Recheneinheit aufweist.

In weiterer vorteilhafter Ausgestaltung der Erfindung ist weiter vorgesehen, dass die Steuereinheit mit einem übergeordneten Steuergerät, bevorzugt über eine vorzugsweise als serielles Bussystem ausgebildete Datenverbindung, kommuniziert.

Eine besonders vorteilhafte Anwendung des erfindungsgemäßen Systems besteht darin, dass das piezoelektrische Element zur Ansteuerung eines Injektors einer Brennkraftmaschine eingesetzt wird.

Weitere Vorteile und vorteilhafte Ausgestaltungen der Erfindung sind der nachfolgenden Zeichnung, deren Beschreibung und den Patentansprüchen entnehmbar.

### Zeichnungen

Es zeigen:
- Figur 1: eine schematische Darstellung eines in eine übergeordnete Steuerung eingebundenen erfindungsgemäßen Systems,
- Figuren 2, 3a, 3b: Beispiele nicht erfindungsgemäßer Systeme und
- Figuren 3c, 3d, 4a, 4b: schematische Darstellungen von Ausführungsformen erfindungsgemäßer Systeme.

### Beschreibung der Ausführungsbeispiele

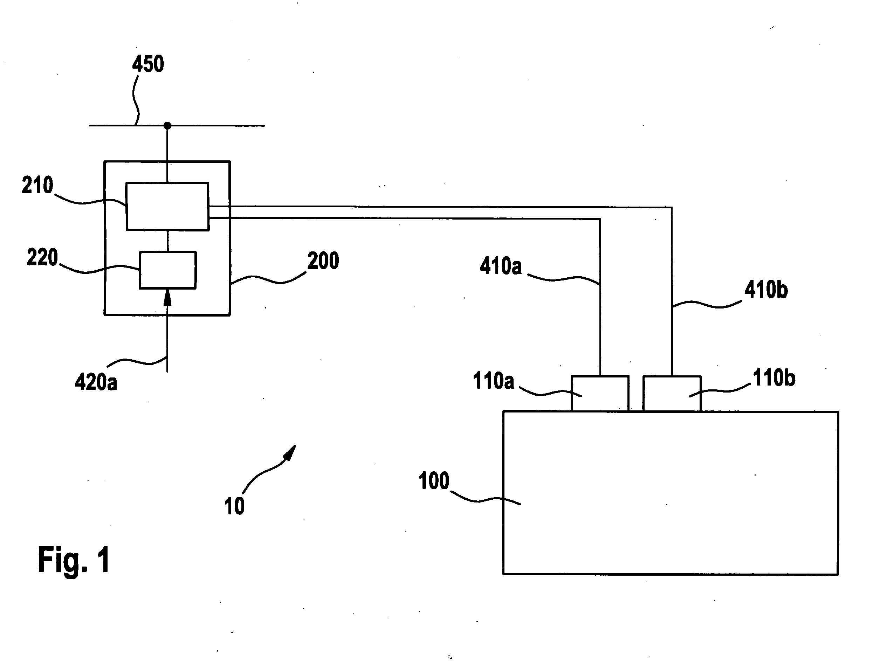

Das Blockschaltbild in Figur 1 zeigt eine Ausführungsform des erfindungsgemäßen Systems 10 zum Betreiben eines piezoelektrischen Elements. Dem System 10 ist ein Steuergerät 200 übergeordnet. Dieses Steuergerät 200 ist unter anderem mit einer Recheneinheit 210 ausgestattet. Die Recheneinheit ist vorzugsweise als Mikrocontroller, digitaler Signalprozessor, anwendungsspezifische integrierte Schaltung oder dergleichen ausgebildet und arbeitet ein Computerprogramm ab, das bei dem vorliegenden Ausführungsbeispiel ein Betriebsverfahren für eine Brennkraftmaschine 100 realisiert. Zur Kommunikation mit weiteren Steuergeräten eines die Brennkraftmaschine 100 aufweisenden Kraftfahrzeugs (nicht dargestellt) weist das Steuergerät 200 eine Busanbindung 450 auf, bei der es sich beispielsweise um einen CAN-Bus handeln kann. Ferner verfügt das Steuergerät 200 über Sensormittel 220, die zur Erfassung von Betriebsgrößen 420 der Brennkraftmaschine 100 vorgesehen sind. Basierend auf diesen Betriebsgrößen 420a ermittelt die Recheneinheit des Steuergeräts 200 nach Vorgabe des auf der Recheneinheit 210 ablaufenden Betriebsverfahrens beziehungsweise -programms Ansteuersignale für die piezoelektrischen Aktoren von Injektoren 1 l0a und 110b. Die Injektoren 110a und 110b dienen dazu, Kraftstoff in die Brennräume (nicht dargestellt) der Brennkraftmaschine 100 einzuspritzen. Im Gegensatz zu herkömmlichen Steuergeräten befinden sich nicht alle elektronischen Baugruppen, die zur Ansteuerung der piezoelektrischen Injektoren 110a und 110b erforderlich sind, in dem Steuergerät 200. Vielmehr sind Teile dieser Funktionen in eine Steuereinheit (nicht dargestellt) ausgelagert, die sich in den Injektoren 110a und 110b befinden.

Infolgedessen sind das Steuergerät 200 und die Injektoren 110a und 110b über Signalleitungen 410a und 410b miteinander verbunden. Die Stromversorgung der Injektoren 110a und 110b ist in Figur 1 nicht dargestellt. Durch die erfindungsgemäße räumliche Trennung zwischen dem übergeordneten Steuergerät und der Steuereinheit an den piezoelektrischen Elementen ist es möglich, das übergeordnete Steuergerät an einem geschützten, vibrationsarmen Platz in einem Motorraum eines Kraftfahrzeugs anzuordnen. Dadurch wird die Zuverlässigkeit und Lebensdauer des übergeordneten Steuergeräts erhöht.

Ein weiterer Vorteil, der sich aus einer derartigen erfindungsgemäßen Anordnung ergibt, ist die Tatsache, dass entweder keine Verbindungsleitungen oder nur noch sehr kurze Verbindungsleitungen zwischen den Leistungsendstufen in der Steuereinheit und den piezoelektrischen Aktoren vorhanden sind. Da diese Verbindungsleitungen üblicherweise mit großen Strömen von bis zu einigen Ampere beaufschlagt werden, die darüber hinaus mit verhältnismäßig großen Frequenzen geschaltet werden, wird durch eine Verkürzung beziehungsweise den Entfall solcher Verbindungsleitungen eine besonders wirksame Verbesserung der elektromagnetischen Verträglichkeit (EMV) des erfindungsgemäßen Systems erreicht.

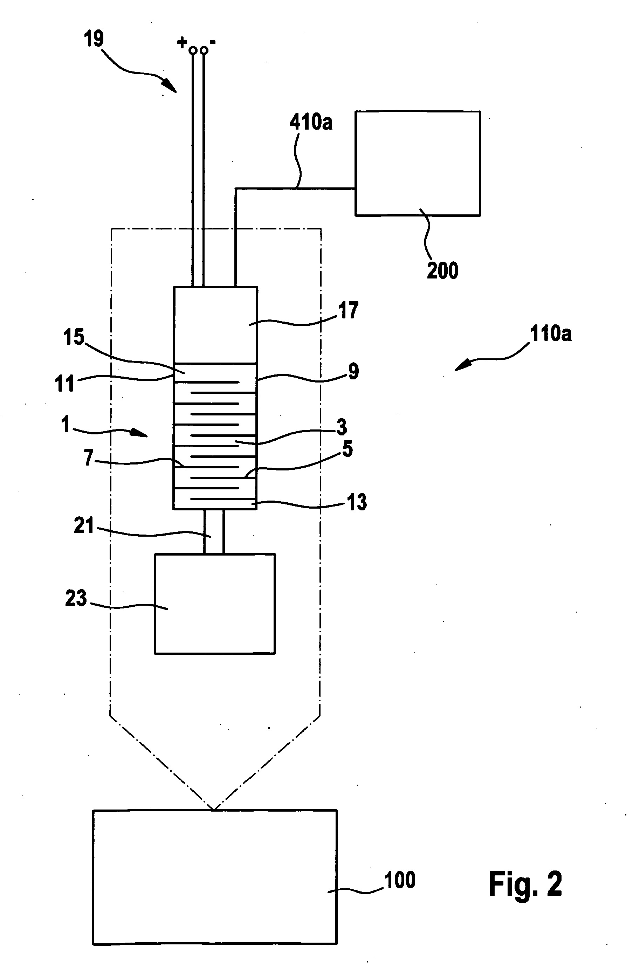

Der prinzipielle Aufbau des Systems 10 wird nachfolgend anhand der Figur 2 näher erläutert. In dem Injektor 110a ist ein als piezoelektrischer Aktor ausgebildetes piezoelektrisches Element in seiner Gesamtheit mit dem Bezugszeichen 1 versehen. Der piezoelektrische Aktor 1 besteht aus einer Vielzahl von übereinander angeordneten Keramikschichten 3, die einen so genannten Multilayer-Stapel bilden. Zwischen den piezoelektrischen Keramikschichten, von denen aus Gründen der Übersichtlichkeit nicht alle mit Bezugszeichen versehen sind, sind Elektrodenschichten 5 und 7 angeordnet. Auch hier sind aus Gründen der Übersichtlichkeit nicht alle Elektrodenschichten 5 und 7 mit Bezugszeichen versehen worden.

Die mit dem Bezugszeichen 5 versehenen Elektrodenschichten bilden eine erste Gruppe und sind mit einer ersten Außenelektrode 9 elektrisch leitend verbunden. Die mit dem Bezugszeichen 7 versehenen Elektrodenschichten bilden eine zweite Gruppe und sind mit einer zweiten Außenelektrode 11 elektrisch leitend verbunden.

Durch Anlegen einer elektrischen Spannung an die Außenelektroden 9 und 11 bildet sich zwischen den Elektrodenschichten 5 und 7 ein elektrisches Feld aus, welches den piezoelektrischen Effekt in den Keramikschichten 3 verursacht.

Unterhalb der untersten Elektrodenschicht 5 und oberhalb der obersten Elektrodenschicht 7 sind eine piezoelektrisch nicht aktive Kopfplatte 13 und eine piezoelektrisch nicht aktive Fußplatte 15 vorhanden. Bei dem in Figur 2 dargestellten Beispiel des Systems 10 ist oberhalb der Fußplatte 15 eine erfindungsgemäße Steuereinheit 17 vorgesehen. Diese Steuereinheit 17 kann eines oder mehrere Substrate umfassen, in oder auf den elektronische Schaltungen, wie beispielsweise eine Leistungsendstufe, realisiert sind. Diese Substrate sind in dem Blockschaltbild gemäß Figur 2 nicht gesondert dargestellt. Über die Signalleitung 410a ist die Steuereinheit 17 mit dem übergeordneten Steuergerät 200 verbunden. Des Weiteren ist die Steuereinheit 17, weil sie bei diesem Beispiel eine Leistungsendstufe enthält, mit einer Stromversorgung 19 verbunden. Über die Stromversorgung 19 wird die zum Ansteuern des piezoelektrischen Aktors 1 erforderliche Energie bereitgestellt. Die Außenelektroden 9 und 11 sind mit den nicht dargestellten Ausgängen der Steuereinheit 17 elektrisch verbunden.

Bei dem in Figur 2 dargestellten Beispiel hat die Steuereinheit 17 ein eigenes Substrat, welches direkt auf die Fußplatte 15 aufgesetzt ist. Die elektrische Verbindung zwischen den Ausgängen der Steuereinheit 17 und den Außenelektroden 9 und 11 ist in der schematischen Darstellung von Figur 2 nicht dargestellt. An dem in Figur 2 unteren Ende des Piezoaktors 1 ist an der Kopfplatte 3 ein Koppelglied 21 vorgesehen, welches den Hub des Aktors 1 auf ein Ventilelement 23 überträgt. Durch Betätigen des Ventilelements 23 kann eine Einspritzung des Injektors 110 in den Brennraum der Brennkraftmaschine 100 gesteuert werden. Schon die schematische und stark vereinfachte Darstellung des Systems gemäß Figur 2 zeigt einen wesentlichen Vorteil des Systems sehr deutlich: Die elektrische Leistung, welche zum Betätigen des piezoelektrischen Aktors 1 erforderlich ist, wird über eine Stromversorgung 19 direkt in die Steuereinheit 17 und den piezoelektrischen Aktor 1 geleitet. Diese elektrische Leistung gelangt nicht in das übergeordnete Steuergerät 200, so dass die bei der Ansteuerung des piezoelektrischen Aktors 1 entstehende Verlustleistung nicht den Temperaturhaushalt des übergeordneten Steuergeräts 200 belastet. Über die Signalleitung 410a werden lediglich Steuersignale übertragen, die nur eine sehr geringe elektrische Leistung erfordern.

Bei dem Beispiel gemäß Figur 2 ist das Substrat der Steuereinheit auf die Kopfplatte 15 des piezoelektrischen Aktors 1 aufgesetzt. Da die Fußplatte 15 keinen Beitrag zum Hub des piezoelektrischen Aktors 1 leistet, ist es auch möglich, dass die Kopfplatte aus dem Substrat der Steuereinheit 17 gebildet wird.

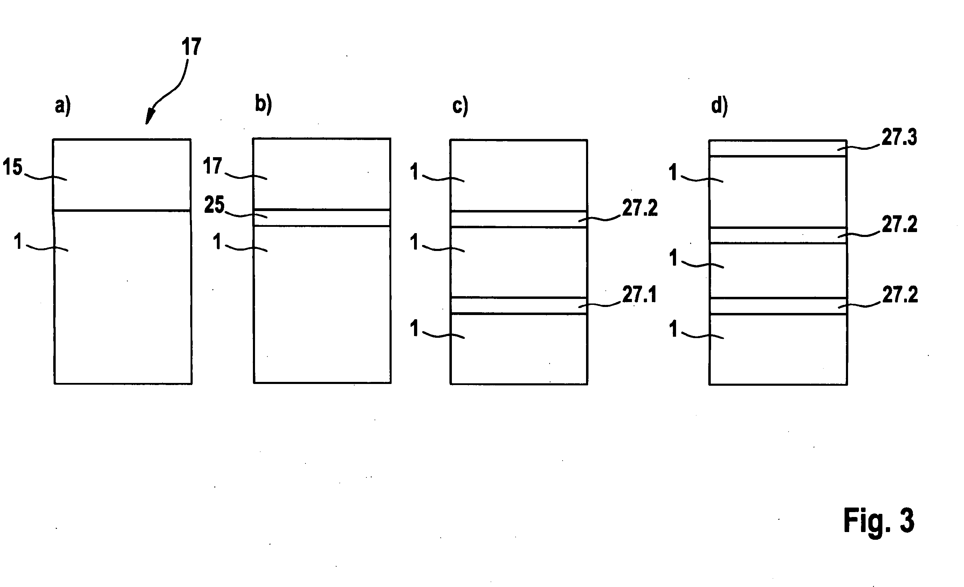

In Figur 3a ist ein piezoelektrisches Element 1 schematisch dargestellt, dessen Fußplatte 15 gleichzeitig das Substrat der Steuereinheit bildet. Bei dem Ausführungsbeispiel gemäß Figur 3b ist zwischen dem piezoelektrischen Element 1 und der Steuereinheit 17 ein Zwischensubstrat 25 vorgesehen. Dieses Zwischensubstrat 25 kann aus dem gleichen Material wie das Substrat der Steuereinheit 17 oder aus dem gleichen Material wie die keramischen Schichten 3 des piezoelektrischen Elements 1 bestehen. Selbstverständlich ist es auch möglich, dass das Zwischensubstrat 25 aus einem dritten Material besteht. Das Zwischensubstrat 25 dient dazu, die Steuereinheit 17 mit dem piezoelektrischen Element 1 zu verbinden. Gleichzeitig kann durch das Zwischensubstrat 25 hindurch auch die elektrische Verbindung zwischen den Außenelektroden 9 und 11 (siehe Figur 2) und der Steuereinheit 17 erfolgen.

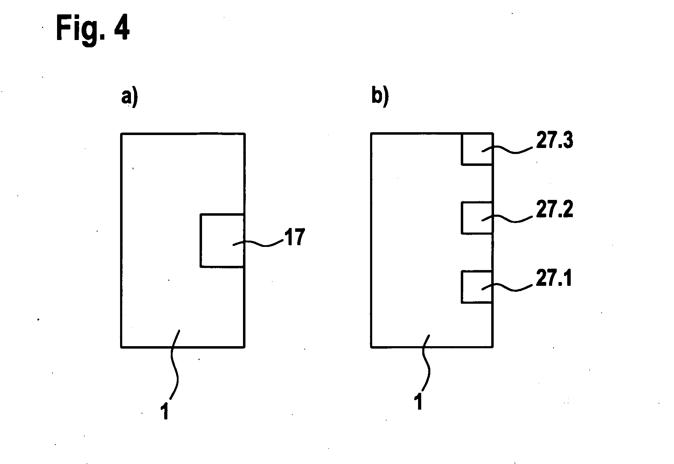

In den Figuren 3c, 3d, 4a und 4b sind verschiedene Ausführungsbeispiele erfindungsgemäßer piezoelektrischer Elemente mit integrierter Steuereinheit schematisch dargestellt.

In Figur 3c ist ein erstes Ausführungsbeispiel eines erfindungsgemäßen Systems schematisch dargestellt. Bei diesem Ausführungsbeispiel ist die Steuereinheit 17 aufgeteilt, so dass Teilsubstrate 27.1 und 27.2 vorhanden sind. Diese Teilsubstrate 27.1 und 27.2 sind zwischen keramischen Schichten des piezoelektrischen Elements 1 angeordnet.

Einen ähnlichen Aufbau zeigt das Ausführungsbeispiel gemäß Figur 3d. Bei diesem Ausführungsbeispiel ist zusätzlich zu den Teilsubstraten 27.1 und 27.2 am Fuß des piezoelektrischen Elements 1 noch ein weiteres Teilsubstrat 27.3 vorgesehen. Den Systemen gemäß der Figuren 3a - 3d ist gemeinsam, dass die Steuereinheit 17 beziehungsweise die Teilsubstrate 27 der Steuereinheit 17 sich über die gesamte Querschnittsfläche des piezoelektrischen Elements 1 erstrecken.

Bei den Ausführungsbeispielen gemäß den Figuren 4a und 4b ist die Steuereinheit 17 beziehungsweise sind die Teilsubstrate 27.1, 27.2 und 27.3 der Steuereinheit 27 in das piezoelektrische Element 1 eingebettet. Sie erstrecken sich nicht über die gesamte Querschnittsfläche des piezoelektrischen Elements 1. Die Teilsubstrate 27 können Teilfunktionen der Steuereinheit 17 übernehmen. So kann beispielsweise ein erstes Teilsubstrat 27.1 als Leistungsendstufe ausgebildet sein, während ein zweites Teilsubstrat 27.2 dazu dient, beim Betrieb des piezoelektrischen Elements 1 als Sensor die Ausgangssignale des piezoelektrischen Sensors 1 auszuwerten und in geeignete Ausgangsgrößen umzuwandeln.

Die erfindungsgemäße Anordnung von piezoelektrischem Element 1 und Steuereinheit 17 in einer Einheit kann bei vielen Anwendungen erfolgreich eingesetzt werden. Besonders bevorzugte Anwendungen sind der Einsatz in Ventilen, wie sie bspw. in Einspritzventilen oder in Fahrsicherheitssystemen, wie ABS, ASR und anderem mehr eingesetzt werden.

## Patentansprüche

1. System zum Betreiben eines piezoelektrischen Elements, wobei das System (10) ein piezoelektrisches Element (1) und eine Steuereinheit (17) zum Ansteuern des Elements (1) aufweist, wobei das Element (1) einen Stapel aus mehreren piezoelektrischen Keramikschichten (3) umfasst, wobei zwischen den Keramikschichten (3) jeweils eine Elektrodenschicht (5, 7) vorgesehen ist, wobei die Steuereinheit (17) mindestens ein Substrat (27) umfasst, **dadurch gekennzeichnet, dass** das oder die Substrate (27, 27.1, 27.2) der Steuereinheit (17) zwischen mehreren keramischen Schichten (3) des Elements (1) angeordnet sind.

2. System nach Anspruch 1, **dadurch gekennzeichnet, dass** das piezoelektrische Element (1) als piezoelektrischer Aktor und/oder als piezoelektrischer Sensor ausgebildet ist.

3. System nach einem der vorhergehenden Ansprüche, **dadurch gekennzeichnet, dass** die Steuereinheit (17) eine Leistungsendstufe umfasst, und dass die Leistungsendstufe auf einem ersten Teilsubstrat (27.1) der Steuereinheit (17) angeordnet ist.

4. System nach einem der vorhergehenden Ansprüche, **dadurch gekennzeichnet, dass** die Steuereinheit (17) ein zweites Teilsubstrat (27.2) umfasst, und dass das weite Teilsubstrat (27.2) eine integrierte Schaltung für die Auswertung eines oder mehrerer piezoelektrischer Sensoren aufweist.

5. System nach einem der vorhergehenden Ansprüche, dass die Steuereinheit (17) eine vorzugsweise als anwendungsspezifische integrierte Schaltung, ASIC oder als Microcontroller ausgebildete Recheneinheit aufweist.

6. System nach einem der vorhergehenden Ansprüche, dass die Steuereinheit (17) mit einem übergeordneten Steuergerät (200), bevorzugt über eine vorzugsweise als serielles Bussystem ausgebildete Datenverbindung (410a), kommuniziert.

7. System nach einem der vorhergehenden Ansprüche, **dadurch gekennzeichnet, dass** die Elektrodenschichten (5, 7) des piezoelektrischen Elements (1) durch zwei Außenelektroden (9,11) kontaktiert sind.

8. System nach einem der vorhergehenden Ansprüche, **dadurch gekennzeichnet, dass** das piezoelektrische Element (1) zur Ansteuerung eines Injektors (110a, 110b) einer Brennkraftmaschine einsetzbar ist.

9. System nach einem der vorhergehenden Ansprüche, **dadurch gekennzeichnet, dass** das piezoelektrische Element (1) in einem elektrisch betätigten Ventil, insbesondere einem Druckregelventil für ein Anti-Blockier-System (ABS) eines Fahrzeugs, integriert ist.

## Claims

1. System for operating a piezoelectric element, the system (10) having a piezoelectric element (1) and a control unit (17) for activating the element (1), the element (1) comprising a stack of multiple piezoelectric ceramic layers (3), an electrode layer (5, 7) being respectively provided between the ceramic layers (3), and the control unit (17) comprising at least one substrate (27),
**characterized in that** the substrate or substrates (27, 27.1, 27.2) of the control unit (17) are arranged between a number of ceramic layers (3) of the element (1).

2. System according to Claim 1, **characterized in that** the piezoelectric element (1) is formed as a piezoelectric actuator and/or as a piezoelectric sensor.

3. System according to one of the preceding claims,
**characterized in that** the control unit (17) comprises a power output stage, and **in that** the power output stage is arranged on a first part-substrate (27.1) of the control unit (17).

4. System according to one of the preceding claims,
**characterized in that** the control unit (17) comprises a second part-substrate (27.2), and **in that** the second part-substrate (27.2) has an integrated circuit for the evaluation of one or more piezoelectric sensors.

5. System according to one of the preceding claims, **characterized in that** the control unit (17) has a computing unit, preferably formed as an application-specific integrated circuit, ASIC, or as a microcontroller.

6. System according to one of the preceding claims,
**characterized in that** the control unit (17) communicates with a higher-level control device (200), with preference via a data link (410a), preferably formed as a serial bus system.

7. System according to one of the preceding claims, **characterized in that** the electrode layers (5, 7) of the piezoelectric element (1) are contacted by two outer electrodes (9, 11).

8. System according to one of the preceding claims, **characterized in that** the piezoelectric element (1) can be used for activating an injector (110a, 110b) of an internal combustion engine.

9. System according to one of the preceding claims, **characterized in that** the piezoelectric element (1) is integrated in an electrically actuated valve, in particular a pressure control valve, for an antilock braking system (ABS) of a vehicle.

## Revendications

1. Système d'utilisation d'un élément piézoélectrique, le système (10) présentant un élément piézoélectrique (1) et une unité de commande (17) qui commande l'élément (1),
l'élément (1) comprenant un empilement de plusieurs couches céramiques piézoélectriques (3),
des couches respectives d'électrode (5, 7) étant prévues entre les couches céramiques (3) et
l'unité de commande (17) comprenant au moins un substrat (27),
**caractérisé en ce que**
le ou les substrats (27, 27.1, 27.2) de l'unité de commande (17) sont disposés entre plusieurs couches céramiques (3) de l'élément (1).

2. Système selon la revendication 1, **caractérisé en ce que** l'élément piézoélectrique (1) est configuré comme actionneur piézoélectrique et/ou comme détecteur piézoélectrique.

3. Système selon l'une des revendications précédentes, **caractérisé en ce que** l'unité de commande (17) comprend un étage terminal de puissance et **en ce que** l'étage terminal de puissance est disposé sur un premier substrat partiel (27.1) de l'unité de commande (17).

4. Système selon l'une des revendications précédentes, **caractérisé en ce que** l'unité de commande (17) présente un deuxième substrat partiel (27.2) et **en ce que** le deuxième substrat partiel (27.2) présente un circuit intégré d'évaluation d'un ou de plusieurs détecteurs piézoélectriques.

5. Système selon l'une des revendications précédentes**, caractérisé en ce que** l'unité de commande (17) présente une unité de calcul configurée de préférence comme circuit intégré spécifique à l'application, comme ASIC ou comme microcontrôleur.

6. Système selon l'une des revendications précédentes, **caractérisé en ce que** l'unité de commande (17) communique avec un appareil de commande (200) d'ordre hiérarchique plus élevé, de préférence par l'intermédiaire d'une liaison de données (410a) configurée comme système de bus série.

7. Système selon l'une des revendications précédentes, **caractérisé en ce que** le contact avec les couches d'électrode (5, 7) de l'élément piézoélectrique (1) est établi à l'aide de deux électrodes extérieures (9, 11).

8. Système selon l'une des revendications précédentes, **caractérisé en ce que** l'élément piézoélectrique (1) peut être utilisé pour commander un injecteur (110a, 110b) d'un moteur à combustion interne.

9. Système selon l'une des revendications précédentes, **caractérisé en ce que** l'élément piézoélectrique (1) est intégré dans une soupape actionnée électriquement, en particulier une soupape de régulation de pression du système antiblocage (ABS) d'un véhicule.
